# EUROPEAN PATENT SPECIFICATION

(11) **EP 3 461 303 B1**
(45) Date of publication and mention of the grant of the patent: **18.12.2019**
(21) Application number: 17846890.6
(22) Date of filing: 18.08.2017
(51) Int. Cl.: H04L 29/06, H03M 7/30, H04N 19/436

(54) **SERVER DEVICE, USER TERMINAL DEVICE, CONTROL METHODS THEREOF AND STREAMING SYSTEM**
SERVERVORRICHTUNG, BENUTZERENDGERÄTEVORRICHTUNG, STEUERUNGSVERFAHREN DAFÜR UND STREAMING-SYSTEM
DISPOSITIF SERVEUR, DISPOSITIF TERMINAL D'UTILISATEUR, PROCÉDÉS DE COMMANDE ASSOCIÉS, ET SYSTÈME DE DIFFUSION EN CONTINU

(30) Priority: 29.08.2016 KR 20160109986
(43) Date of publication of application: 03.04.2019
(73) Proprietor: Samsung Electronics Co., Ltd., Suwon-si, Gyeonggi-do 16677 (KR)
(72) Inventor: MEDURI, Chandra Sekhar, Gyeonggi-do, 16677 (KR); KIM, Beung-chan, Gyeonggi-do, 16677 (KR)
(74) Representative: Appleyard Lees IP LLP
(86) International application number: PCT/KR2017/009023
(87) International publication number: WO 2018/043965

(56) References cited:
- US-A1- 2005 144 643
- US-A1- 2007 133 678
- US-A1- 2008 152 014
- US-A1- 2010 322 334
- US-A1- 2013 058 395
- US-A1- 2015 229 329
- US-A1- 2015 229 329
- US-A1- 2016 007 025

## Description

### Technical Field

The present disclosure relates generally to a server device, a user terminal device, control methods thereof and a streaming system, and for example, to a server device configured to provide streaming service for a high capacity content, a user terminal device, control methods thereof and a streaming system.

### Background Art

High definition images such as full high definition (FHD) content and ultra high definition (UHD) content are supplied with development of the electronic technology. Specifically, a technology for not only compressing high definition content, but also providing streaming service in real time is supplied.

US2008/152014 discloses a system in which video frames are encoded by parallel encoding units. The output of the encoding units are combined in one signal and transmitted to a receiver. At the receiver the received signal is split into data units which are given to parallel decoders for decoding.

US2015/229329 discloses a system which uses parallel processors for encoding data. The encoded data from the parallel encoders are transmitted using parallel transmission links to a similar number of decoders which correspondingly decode the data encoded by each encoder.

US2007/133678 discloses a system in which video frames are encoded using parallel encoders. The outputs of the parallel encoders are combined in one signal for transmission.

### Disclosure of Invention

### Technical Problem

However, in order to provide high definition content, an image compression technology having high efficiency is necessary. For example, in order to process a RGB image having 8 bits per 1280x720 resolution (HD) component sample by 30 pages per second, it means that the 663,552,000 (1280x720x8x3x30) bps have to be processed, while, to process a RGB image having 8 bits per 3840x2160 resolution (UHD) component sample by 30 pages per second, it means that 5,971,968,000 (3840x2160x8x3x30) bps have to be processed. In other words, as resolution of content increases, bits to be processed increase exponentially, and there occurs difficulty of transmitting the content in real time.

Accordingly, a new technology to provide streaming service for high definition content in real time is necessary.

### Solution to Problem

Example embodiments of the present disclosure address the above disadvantages and other disadvantages not described above.

According to an example embodiment, a server device which provides streaming service for a high capacity content, a user terminal device, control methods thereof and a streaming system are provided.

According to an example embodiment, a server device is provided, which may include a communicator comprising communication circuitry configured to perform communication with a user terminal device, a plurality of encoders configured to perform encoding in parallel, and a processor configured to sequentially allocate frames generated in real time to the plurality of encoders, and to control the communicator so that a plurality of encoded frames output in parallel from the plurality of encoders are streamed individually to the user terminal device.

The plurality of encoders may include a first encoder and a second encoder, and the processor may allocate odd-numbered frames of the frames generated in real time to the first encoder and allocate even-numbered frames to the second encoder.

When a re-request signal for a certain frame is received from the user terminal device, the processor may first re-transmit the certain frame if the certain frame is a frame encoded in a first encoding type, and if the certain frame is a frame encoded in a second encoding type, the processor may first re-transmit the frame encoded in the first encoding type after the certain frame of the encoded frames is output from the encoder that encodes the certain frame.

When a re-request signal for a certain frame is received from the user terminal device, the processor may first re-transmit the certain frame if the certain frame is an intra frame, and if the certain frame is an inter frame, the processor may first re-transmit an intra frame after the certain frame of the encoded frames is output from the encoder that encodes the certain frame.

When a frame including video data and a frame including UI data provided with the video data is generated, the processor may allocate a frame including the UI data to one of the plurality of encoders, and sequentially allocate a frame including the video data to rest of the plurality of encoders.

In an example embodiment, a user terminal device is provided, which may include a display, a communicator comprising communication circuitry configured to perform communication with a server device, a plurality of decoders configured to perform decoding in parallel, at least one buffer connected to the plurality of decoders, and a processor configured to sequentially allocate to a plurality of decoders a plurality of encoded frames output in parallel from a plurality of encoders provided in the server device and streamed individually from the server device, to store a plurality of decoded frames output in parallel from the plurality of decoders in at least one buffer, and to display the plurality of decoded frames in order on the display based on identification information included in the plurality of decoded frames stored in the at least one buffer.

The processor may transmit a re-request signal for a certain frame to the server device when an error occurs in the decoding of a certain frame, and display in order a plurality of frames output from rest decoders other than the decoder corresponding to the certain frame from among the plurality of decoders.

The processor may sequentially allocate to the plurality of decoders an encoded frame including video data individually streamed from the server device, and an encoded frame including UI data provided with the video data, synchronize the decoded video data frame with the decoded UI data frame output respectively from the plurality of decoders, and display a result.

In an example embodiment, a streaming system is provided, which may include a server comprising a plurality of encoders configured to perform encoding in parallel, and configured to sequentially allocate frames generated in real time to a plurality of encoders and individually stream a plurality of encoded frames output in parallel from the plurality of encoders to the user terminal device, and a user terminal device including a display, a plurality of decoders configured to perform decoding in parallel, and at least one buffer connected to the plurality of decoders, and configured to sequentially allocate a plurality of encoded frames streamed from the server device to the plurality of decoders, to store the plurality of decoded frames output in parallel from the plurality of decoders in at least one buffer, and to display in order the plurality of decoded frames on the display based on identification information included in the plurality of decoded frames stored in the at least one buffer.

In an example embodiment, a control method of a server device is provided, which may include sequentially allocating frames generated in real time to a plurality of encoders for performing encoding in parallel, and individually streaming a plurality of encoded frames output in parallel from the plurality of encoders to a user terminal device.

The plurality of encoders may include a first encoder and a second encoder, and the allocating may include allocating odd-numbered frames of the frames generated in real time to the first encoder and allocating even-numbered frames to the second encoder.

The control method may further include receiving a re-request signal for a certain frame from the user terminal device, and re-transmitting the certain frame when the certain frame is a frame encoded in a first encoding type, and when the certain frame is a frame encoded in a second encoding type, re-transmitting the frame encoded in the first encoding type after the certain frame of encoded frames is output from the encoder that encodes the certain frame.

The re-transmitting may include first re-transmitting the certain frame when the certain frame is an intra frame, and when the certain frame is an inter frame, first re-transmitting the intra frame after the certain frame of encoded frames is output from the encoder that encodes the certain frame.

When a frame including video data and a frame including UI data provided with the video data is generated, the allocating may include allocating the frame including the UI data to one of the plurality of encoders, and sequentially allocating the frame including the video data to rest of the plurality of encoders.

In an example embodiment, a control method of a user terminal device is provided, in which the user terminal device receives a plurality of encoded frames output in parallel from a plurality of encoders provided in a server device and streamed, and processes the same, and the control method includes allocating a plurality of individually-streamed, encoded frames from the server device sequentially to a plurality of decoders for performing decoding in parallel, storing a plurality of decoded frames output in parallel from the plurality of decoders in at least one buffer connected to the plurality of decoders, and displaying the plurality of decoded frames in order based on identification information included in the plurality of decoded frames stored in the at least one buffer.

The control method may further include transmitting a re-request signal for a certain frame to the server device when an error occurs in the decoding of the certain frame. The displaying may include displaying in order a plurality of frames output from rest decoders other than the decoder corresponding to the certain frame among the plurality of decoders.

The allocating may further include sequentially allocating an encoded frame including video data individually streamed from the server device and an encoded frame including UI data provided with the video data, synchronizing the decoded UI data frame output respectively from a plurality of decoders with the decoded video data frame, and displaying a result.

According to the above various example embodiments, the server device and the user terminal device may provide high quality of streaming service using a plurality of encoders and a plurality of decoders and processing high capacity content.

The invention is defined by a server device according to independent claim 1, a user terminal according to independent claim 5 and a method in a server device according to independent claim 7.

### Brief Description of Drawings

The above and/or other aspects, features and attendant advantages of the present disclosure will be more apparent and readily appreciated from the following detailed description, taken in conjunction with the accompanying drawings, in which like reference numerals refer to like elements, and wherein:
FIG. 1 is a diagram illustrating an example streaming system according to an example embodiment;
FIG. 2 is a block diagram illustrating an example server device according to an example embodiment;
FIG. 3 is a diagram illustrating an example streaming operation of a server device according to an example embodiment;
FIG. 4 is a diagram illustrating an example operation when a re-request signal for a certain frame is received according to an example embodiment;
FIGS. 5A and 5B are diagrams illustrating an example method for allocating a multi-window frame according to an example embodiment;
FIG. 6 is a block diagram illustrating an example user terminal device according to an example embodiment;
FIG. 7 is a diagram illustrating an example content display operation of a user terminal device according to an example embodiment;
FIG. 8 is a diagram illustrating an example operation of transmitting a re-request signal for a certain frame according to an example embodiment;
FIG. 9 is a diagram illustrating an example method for restoring a multi-window frame according to an example embodiment;
FIG. 10 is a flowchart illustrating an example control method of a server device according to an example embodiment; and
FIG. 11 is a flowchart illustrating an example control method of a user terminal device according to an example embodiment.

### Mode for the Invention

Referring to the attached drawings, various example embodiments of the present disclosure will be described in greater detail below. It should be understood that the matters defined in the description may not limit a scope of the disclosure, but include various modifications, equivalents and/or alternatives of the example embodiments. With respect to explanation of drawings, the same or similar drawing reference numerals may be used in similar constituent elements.

Further, when it is mentioned that one element (e.g., first element) is operatively or communicatively coupled with or connected to another element (e.g., second element), this should be understood as including all the examples where each of the elements is directly coupled or indirectly coupled via yet another element (e.g., third element). Meanwhile, when it is mentioned that one element (e.g., first element) is "directly coupled" with or "directly connected to" another element (e.g., second element), it may be understood that there is no element (e.g., third element) present between one element and another element.

Terms used in the present disclosure are provided to explain example embodiments, and are not be intended to limit a scope of other embodiments. Further, while a singular expression may be used herein for convenience of explanation, unless specified otherwise in the context, it may be interpreted as including a plural expression. Further, terms used in the present disclosure may have same meaning as being understood generally by a person skilled in the art. Terms used in the present disclosure and defined in a general dictionary may be interpreted as having a same or similar meaning according to the context of the related technology, and unless specifically defined otherwise herein, cannot be interpreted as an ideological or excessively formal meaning. Depending on cases, even the terms defined in the present disclosure should not be interpreted as excluding the embodiments of the present disclosure.

Hereinbelow, various example embodiments of the present disclosure will be described in greater detail with reference to the accompanying drawings.

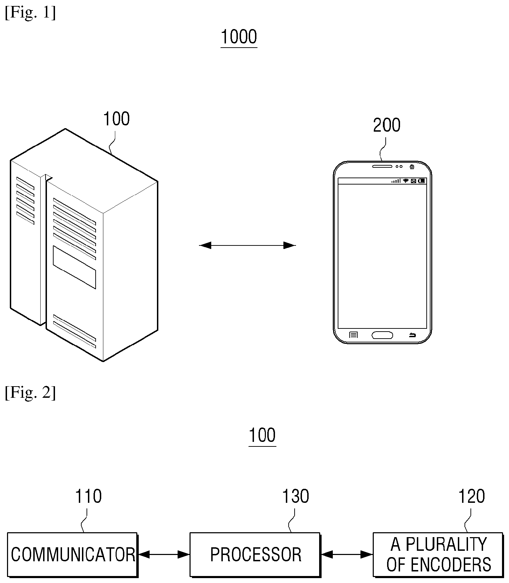

FIG. 1 is a diagram illustrating an example streaming system 1000 according to an example embodiment. As illustrated in FIG. 1, the streaming system 1000 includes a server device 100 and a user terminal device 200.

The server device 100 may perform communication with the user terminal device 200. The server device 100 may transmit content to be provided from the user terminal device 200 in real time. Meanwhile, the server device 100 may receive a re-request signal for a certain frame from the user terminal device 200.

The server device 100 may include a plurality of encoders. A plurality of encoders may perform encoding in parallel. For example, a plurality of encoders may encode in parallel one content divided into a plurality of content. Alternatively, each of a plurality of encoders may encode a plurality of contents in parallel.

The server device 100 may sequentially allocate a plurality of encoders with frames generated in real time. For example, when the server device 100 includes two encoders, the server device 100 may alternately allocate frames generated in real time to the two encoders. Alternatively, the server device 100 may allocate frames in such a manner in which a first frame and a second frame generated in real time are allocated to the first encoder of the two encoders, and a third frame and a fourth frame generated in real time are allocated to the second encoder of the two encoders.

The server device 100 may individually stream a plurality of encoded frames output in parallel from a plurality of encoders to the user terminal device. For example, the server device 100 may individually stream a plurality of encoded frames output in parallel from a plurality of encoders to the user terminal device through a plurality of channels.

The user terminal device 200 may, for example, and without limitation, be any of various electronic devices. For example, it may be implemented as digital camera, MP3 player, PMP, smart phone, cellular phone, smart glasses, tablet PC, smart watch, or various other devices. For example, the user terminal device 200 may be a device equipped with a display.

The user terminal device 200 may perform communication with the server device 100. The user terminal device 200 may receive content provided from the server device 100 in real time. Meanwhile, the user terminal device 200 may transmit a re-request signal for a certain frame to the server device 100.

The user terminal device 200 may include a plurality of decoders. A plurality of decoders may perform decoding in parallel. For example, a plurality of decoders may decode one content, which is divided into a plurality of contents, in parallel. Alternatively, a plurality of decoders may respectively decode a plurality of contents in parallel.

The user terminal device 200 may sequentially allocate a plurality of decoders with a plurality of encoded frames output in parallel from a plurality of encoders provided in the server device 100 and streamed individually from the server device 100.

The user terminal device 200 may store a plurality of decoded frames output in parallel from a plurality of decoders into at least one buffer connected to a plurality of decoders. The user terminal device 200 may display a plurality of decoded frames in order on the display based on identification information included in a plurality of decoded frames stored in at least one buffer.

As described above, the server device 100 may individually stream a plurality of encoded frames to the user terminal device 200. The user terminal device 200 may decode a plurality of individually-streamed, encoded frames and display them in order. In other words, the user terminal device 200 may provide high-capacity content streaming service by dividing one content into a plurality of contents, performing encoding and decoding, and transmitting a result through a plurality of channels.

FIG. 2 is a block diagram illustrating an example server device 100 according to an example embodiment.

As illustrated in FIG. 2, the server device 100 includes a communicator (e.g., including communication circuitry) 110, a plurality of encoders 120, and a processor (e.g., including processing circuitry) 130.

Meanwhile, FIG. 2 briefly illustrates various elements by exemplifying the server device 100 as a device that includes functions such as communication function, encoding function and controlling function. According to an embodiment, some of the elements illustrated in FIG. 2 may be removed and modified, and other new elements may be further added.

The communicator 110 may include various communication circuitry and perform communication with the user terminal device 200. Further, the communicator 110 may transmit content to be provided from the user terminal device 200 in real time. Specifically, the communicator 110 may individually transmit a plurality of encoded frames obtained from the content to the user terminal device 200 through a plurality of channels.

The communicator 110 may transmit quality of service (QoS) information to the user terminal device 200. The QoS information will be described in a later part of the present disclosure.

The communicator 110 may receive a re-request signal for a certain frame from the user terminal device 200. In this case, the communicator 110 may only stop transmission through channels corresponding to a certain frame, while the other channels may keep transmission state irrespective of a re-request signal.

The communicator 110 may perform communication with the user terminal device 200 through various communication methods such as BlueTooth (BT), Bluetooth Low Energy (BLE), Wireless Fidelity (WI-FI), Zigbee, IR (Infrared), Serial Interface, Universal Serial Bus (USB), Near Field Communication (NFC), and so on. Among them, the NFC chip refers to a chip operating in the NFC method which uses 13.56 MHz bandwidth among various RF-ID frequency bandwidths such as 135 kHz, 13.56 MHz, 433 MHz, 860-960 MHz, 2.45 GHz, or the like. When the WI-FI chip or the Bluetooth chip is used, various connection information such as SSID and session key may be first exchanged, communication may be connected by using the connection information, and various information may be exchanged. A wireless communication chip refers to a chip performing communication according to various communication standards such as IEEE, Zigbee, 3^{rd} Generation (3G), 3^{rd} Generation Partnership Project (3GPP), Long Term Evolution (LTE), and so on.

Meanwhile, although it is described above that the communicator 110 is one of the elements, it may be implemented such that a first communicator (not illustrated) for performing communication with the user terminal device 200 and a second communicator (not illustrated) for performing communication with another user terminal device (not illustrated), each including various communication circuitry, are separately provided. Further, a method for communicating with the first communicator may be same as a method for communicating with the second communicator, or they may be different from each other.

A plurality of encoders 120 may perform encoding in parallel. Specifically, a plurality of encoders 120 may encode frames generated in real time in parallel, and convert into another signal form.

A plurality of encoders 120 may perform encoding by dividing each of the frames generated in real time into a plurality of blocks. A plurality of encoders 120 may perform encoding by a series of time or dimension prediction, conversion, quantification, filtering, entropy-encoding, and so on. Specific operation of the encoder is out of a scope of the present disclosure, which will not be specifically explained herein.

A plurality of encoders 120 may be of different types from each other. For example, the first encoder of a plurality of encoders 120 may be HEVC encoder, and the other encoders of a plurality of encoders 120 may be H.264 encoders. However, this may be one embodiment, and constitution of a plurality of encoders 120 may be modified as desired. Further, a plurality of encoders 120 may be all the same as each other.

Each of the encoders may perform intra-encoding or inter-encoding for each of the frames.

The intra-encoding may refer, for example, to an operation of performing encoding through in-screen prediction. Specifically, the intra-encoding may refer, for example, to an operation of performing encoding by spatial prediction from adjacent pixels in the current frame.

The inter-encoding may refer, for example, to an operation of performing encoding through prediction between screens. The encoder may store some reference frames having high correlativity with a frame to be currently encoded, and perform prediction between screens by using the stored frames. In other words, the encoder may perform encoding by time prediction from reference frames of previous frames.

For example, the intra frame may be able to be decoded without reference of another frame during the decoding, while the inter frame is possibly decoded only with reference of another frame during the decoding.

A processor 130 may include various processing circuitry and generally controls the overall operation of the server device 100.

The processor 130 may generate frames to be provided to the user terminal device 200 in real time. For example, the server device 100 may generate frames related with a cloud game running on the user terminal device 200 in real time. In this case, the user terminal device 200 may receive frames from the server device 200 and display them.

The processor 130 may sequentially allocate frames generated in real time to a plurality of encoders 120. For example, a plurality of encoders 120 may include a first encoder and a second encoder, and the processor 130 may allocate odd-numbered frames of the frames generated in real time to the first encoder, and even-numbered frames to the second encoder.

However, this is merely an example embodiment. The processor 130 may allocate a preset number of consecutive frames to the first encoder, and a preset number of consecutive frames to the second encoder. For example, the processor 130 may allocate first to fifth frames to the first encoder, and sixth to tenth frames to the second encoder. Meanwhile, the number of a plurality of encoders 120 may be different.

The processor 130 may control the communicator 110 so that a plurality of encoded frames output from a plurality of encoders 120 in parallel are individually streamed to the user terminal device 200. For example, the processor 130 may transmit the encoded frames output from the first encoder to the user terminal device 200 through a first channel, and transmit the encoded frames output from the second encoder to the user terminal device 200 through a second channel.

Meanwhile, when a re-request signal for a certain frame is received from the user terminal device 200 and when a certain frame is an encoded frame of a first encoding type, the processor 130 may first re-transmit the certain frame. When a certain frame is an encoded frame of a second encoding type, the processor 130 may first re-transmit the encoded frame of a first encoding type after the certain frame among the encoded frames output from the encoder that encodes the certain frame.

Specifically, when a re-request signal for a certain frame is received from the user terminal device 200, the processor 130 may first re-transmit the certain frame when the certain frame is an intra frame, while when the certain frame is an inter frame, first re-transmit an intra frame after the certain frame of encoded frames output from the encoder that encodes the certain frame. In other words, the processor 130 may not perform unnecessary operation of only transmitting an inter frame which it cannot decode itself.

Meanwhile, the processor 130 may generate a frame including video data and a frame including UI data provided with the video data. In an example, the video data may be data displayed on one region of the screen including UI data.

When a frame including video data and a frame including UI data provided with the video data are generated, the processor 130 may allocate the frame including UI data to one of a plurality of encoders 120, and sequentially allocate a frame including the video data to the rest of a plurality of encoders 120.

Specifically, because a frame including UI data does not show big difference between frames, it may be efficient to process this with one encoder. Operation of sequentially allocating a frame including video data to the rest of a plurality of encoders 120 is same as described above.

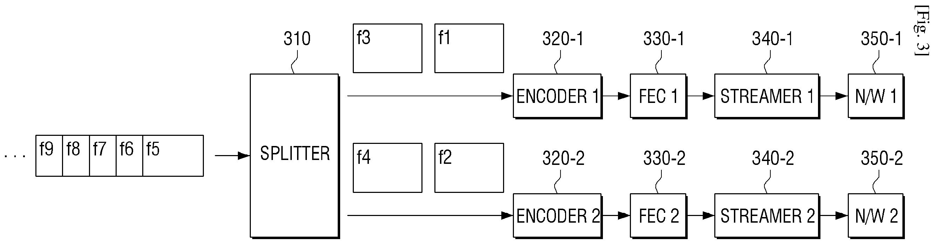

FIG. 3 is a diagram illustrating example streaming of the server device 100 according to an example embodiment. In the following description, for ease of explanation, the frames to be transmitted and its order are represented by f1, f2, ? , f9, ?, the encoded frames and its order are represented by f1', f2', ? , f9', ?, and the decoded frames and its order are represented by f1", f2", ? , f9", ?.

A splitter (e.g., including splitting circuitry) 310 is one of elements of the processor 130, and may sequentially allocate frames generated in real time in the server device 100 to the first encoder 320-1 and the second encoder 320-2. For example, the splitter 310 may allocate odd-numbered frames of the frames generated in real time to the first encoder 320-1, and allocate even-numbered frames to the second encoder 320-2. In an example, the splitter 310 may be referred to as a 'mapper'.

The first encoder 320-1 and the second encoder 320-2 may sequentially encode frames as these are input respectively. In an example, the first encoder 320-1 and the second encoder 320-2 may be different encoders from each other. For example, the first encoder 320-1 may be HEVC encoder and the second encoder 320-2 may be H.264 encoder, but the present disclosure is not limited thereto.

A forward error correction (FEC) 1 block 330-1 may apply forward error correction algorithms to the encoded frames ouput from the first encoder 320-1. A FEC 2 block 330-2 may apply the forward error correction algorithms to the encoded frames output from the second encoder 320-2. In an example, the FEC 1 block 330-1 and the FEC 2 block 330-2 may be elements of the processor 130.

The FEC 1 block 330-1 and the FEC 2 block 330-2 may respectively apply different forward error correction algorithms from each other based on types of the first encoder 320-1 and the second encoder 320-2. For example, when the first encoder 320-1 is HEVC encoder and the second encoder 320-2 is H.264 encoder, the FEC 1 block 330-1 may apply the forward error correction algorithms having higher reliability than the FEC 2 block 330-2.

Specifically, the output encoded frames may have a lower capacity since the HEVC encoder has a higher efficiency than the H.264 encoder. In this case, encoded frames output from the HEVC encoder may be added with more error correction signs than encoded frames output from the H.264 encoder. Specifically, for the transmission channels respectively having uniform capacity, transmission speed may not be greatly varied from each other even if encoded frames output from the HEVC encoder are added with more error correction signs than encoded frames output from the H.264 encoder.

Alternatively, the forward error correction algorithms of each of the FEC 1 block 330-1 and the FEC 2 block 330-2 may be determined based on processing speed of each encoder. For example, when the first encoder 320-1 is the HEVC encoder and the second encoder 320-2 is the H.264 encoder, the FEC 1 block 330-1 may apply the forward error correction algorithms having a faster processing speed than the FEC 2 block 330-2.

Specifically, the HEVC encoder may have a slower processing speed because of a higher complexity than the H.264 encoder. In this case, the FEC 1 block 330-1 may reduce difference in the transmission speed by applying the forward error correction algorithms having a faster processing speed than the FEC 2 block 330-2.

However, this is merely one example embodiment. TheFEC block may determine a type of the forward error correction algorithms based on types of encoded frames output from the encoder. For example, types of the forward error correction algorithms applied to an intra frame and an inter frame may be different from each other.

A streamer 1 340-1 and a streamer 2 340-2 may individually stream respectively input encoded frames applied with the forward error correction algorithms to the user terminal device 200 through a network 1 350-1 (N/W 1) and a network 2 350-2 (N/W 2). In an example, the network 1 350-1 and the network 2 350-2 may be referred to respectively as channel 1 and channel 2.

Meanwhile, the processor 130 may transmit QoS information to the user terminal device 200. In an example, QoS information may include information regarding a type of the encoder applied to the encoded frames transmitted through each network and a type of the forward error correction algorithms.

Although FIG. 3 describes that two encoders are used, any other number of encoders may be used. Even in this case, the streaming may be performed by allocating frames with the same method. When a plurality of encoders are used, the first encoder of a plurality of encoders may be HEVC encoder, and the rest of a plurality of encoders may be H.264 encoder, but the present disclosure is not limited thereto.

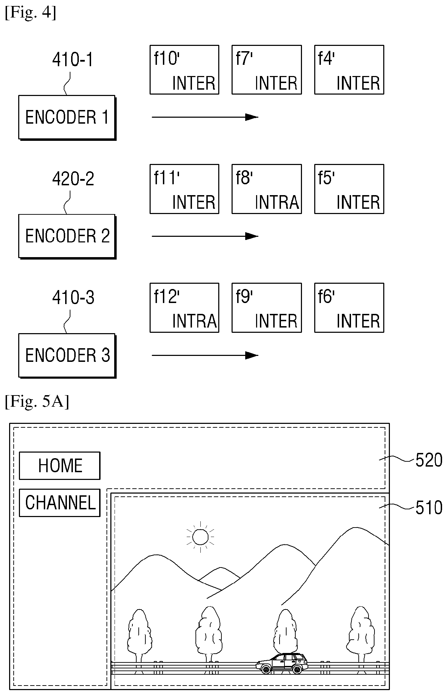

FIG. 4 is a diagram illustrating an example operation when a re-request signal for a certain frame is received according to an example embodiment. In an example, the user terminal device 200 may transmit a re-request signal for a certain frame to the server device 100. For example, the user terminal device 200 may transmit a re-request signal for a certain frame to the server device 100 when a certain frame is not received.

When a re-request signal for a certain frame is received from the user terminal device 200, the processor 130 may first re-transmit a certain frame when the certain frame is an encoded frame of a first encoding type, and when the certain frame is an encoded frame of a second encoding type, first re-transmit an encoded frame of a first encoding type after the certain frame of encoded frames output from the encoder that encodes the certain frame.

Specifically, when a re-request signal for a certain frame is received from the user terminal device 200, the processor 130 may first re-transmit the certain frame when the certain frame is an intra frame, and first re-transmit an intra frame after the certain frame of encoded frames output from the encoder that encodes the certain frame when the certain frame is an inter frame.

For example, as illustrated in FIG. 4, the first encoder 410-1 may sequentially output a fourth encoded frame, a seventh encoded frame, and a tenth encoded frame, the second encoder 410-2 may sequentially output a fifth encoded frame, an eighth encoded frame, and an eleventh encoded frame, and the third encoder 410-3 may sequentially output a sixth encoded frame, a ninth encoded frame, and a twelfth encoded frame. Each of the output encoded frames may be individually transmitted to the user terminal device 200 through each network. Transmission of the other encoded frames will not be described herein.

When a re-request signal for the eighth encoded frame is received from the user terminal device 200, the processor 130 may sequentially re-transmit the eighth encoded frame because the eighth encoded frame is an intra frame. The processor 130 may continuously transmit encoded frames output from the first encoder 410-1 and the third encoder 410-3 to the user terminal device 200.

Meanwhile, when a re-request signal for the fifth encoded frame is received from the user terminal device 200, the processor 130 may sequentially re-transmit the eighth encoded frame which is an intra frame after the fifth encoded frame because the fifth encoded frame is an inter frame. In this case, the processor 130 may continuously transmit encoded frames output from the first encoder 410-1 and the third encoder 410-3 to the user terminal device 200 irrespective of a re-request signal.

Alternatively, when a re-request signal for the sixth encoded frame is received from the user terminal device 200, the processor 130 may sequentially re-transmit the twelfth encoded frame which is an intra frame after the sixth encoded frame because the sixth encoded frame is an inter frame. In this case, the processor 130 may continuously transmit encoded frames output from the first encoder 410-1 and the second encoder 410-2 to the user terminal device 200 irrespective of a re-request signal.

Meanwhile, although FIG. 4 illustrates that a plurality of encoded frames are simultaneously output from the first encoder 410-1, the second encoder 410-2, and the third encoder 410-3 respectively, this is an example provided for convenience of explanation. For example, while the fourth encoded frame is being output from the first encoder 410-1, the eighth encoded frame and the ninth encoded frame may be output respectively from the second encoder 410-2 and the third encoder 410-3. Alternatively, while the fourth encoded frame is being output from the first encoder 410-1, outputting of the fifth encoded frame and the sixth encoded frame respectively from the second encoder 410-2 and the third encoder 410-3 may be finished. This is because there may be a performance difference between each of the encoders.

Again, in this case, the processor 130 may transmit the output encoded frames to the user terminal device 200 through a FEC block without waiting for outputting of the other encoded frames. The user terminal device 200 may receive a plurality of encoded frames irrespective of an order of frames; however, it may display decoded frames in order by using a buffer to be described below.

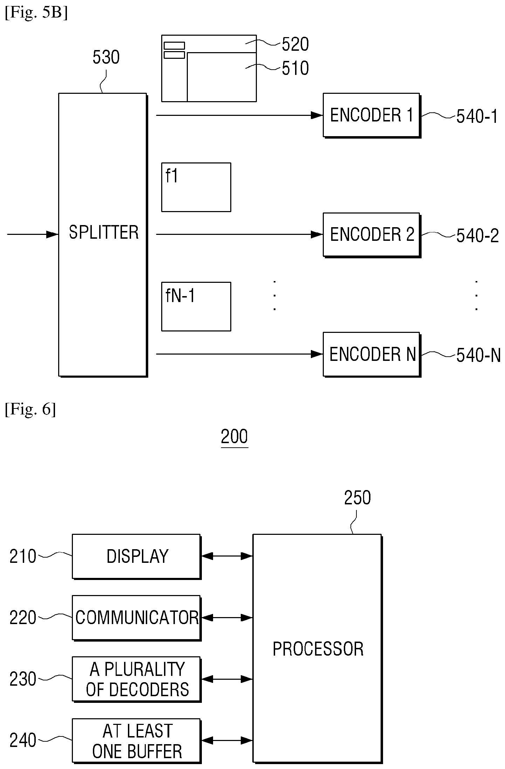

FIGS. 5A and 5B are diagrams illustrating an example method for allocating a multi-window frame according to an example embodiment.

The multi-window frame may include a frame including video data and a frame including UI data provided with the video data. For example, as illustrated in FIG. 5A, the multi-window frame may be a frame overlaid with a frame 510 including video data and a frame 520 including UI data.

As illustrated in FIG. 5B, when the frame 510 including video data and the frame 520 including UI data provided with the video data are generated, the processor 130 may allocate the frame 520 including UI data to one of a plurality of encoders, and sequentially allocate the frame 510 including video data to the rest of a plurality of encoders.

For example, the splitter 530, which may be one of the elements of the processor 130, may allocate the frame 520 including UI data to the first encoder 540-1 of a plurality of encoders. At this process, the processor 130 may process with a preset color a region of the frame 520 including UI data where the video data is to be displayed, and allocate a result to the first encoder 540-1. Since UI data shows no significant changes from the frame 520 including UI data, and a region displaying the video data is uniformly processed with a preset color in all the frames, real-time streaming may be possibly processed even if one encoder is used.

Meanwhile, the splitter 530 may sequentially allocate the frame 510 including the video data to the rest of a plurality of encoders. Because this is same as or similar to the description provided above with reference to FIG. 3, specific explanation will not be repeated.

The processor 130 may transmit a plurality of encoded frames to the user terminal device 200 through a plurality of networks. Further, the processor 130 may transmit to the user terminal device 200 the information regarding a network over which an encoded frame corresponding to the frame 520 including UI data is transmitted and information regarding a network over which a plurality of encoded frames corresponding to the frame 510 including video data is transmitted. Further, the processor 130 may transmit to the user terminal device 200 the information regarding a region that displays video data in the frame 520 including UI data.

FIG. 6 is a block diagram illustrating an example user terminal device 200 according to an example embodiment.

As illustrated in FIG. 6, the user terminal device 200 includes a display 210, a communicator (e.g., including communication circuitry) 220, a plurality of decoders 230, at least one buffer 240, and a processor (e.g., including processing circuitry) 250.

Meanwhile, FIG. 6 briefly illustrates each element by referring to an example in which the user terminal device 200 is a device equipped with a display function, a communication function, a decoding function, a storage function, a control function, and so on. According to various examples, some elements illustrated in FIG. 6 may be removed or modified, or other new elements may be further added.

The display 210 may display a plurality of decoded frames in order under control of the processor 250. For example, the display 210 may display in order a first decoded frame, a second decoded frame, and then on.

However, example embodiments may not be limited to any specific embodiment. Accordingly, the display 210 may skip some frames, while displaying the rest of the frames in order. For example, the display 210 may display in order a first decoded frame, a second decoded frame, a fourth decoded frame, a fifth decoded frame, and then on.

Meanwhile, the display 210 may be implemented as a liquid crystal display panel (LCD), an organic light emitting diodes (OLED), and or the like, but not limited thereto. Further, the display 210 may be implemented as a flexible display, a transparent display, or the like, depending on cases.

The communicator 220 may include various communication circuitry and perform communication with the server device 100. Further, the communicator 220 may receive content provided from the server device 100 in real time. Specifically, the communicator 220 may individually receive a plurality of encoded frames encoded from the content from the server device 100 through a plurality of channels.

The communicator 220 may receive QoS information from the server device 100.

The communicator 220 may transmit a re-request signal for a certain frame to the server device 100. In this case, irrespective of a re-request signal, transmission state may be maintained for the rest channels other than a channel corresponding to the certain frame.

The communicator 220 may perform communication with the user terminal device 200 with various communication methods such as BT, BLE, WI-FI, Zigbee, IR, serial interface, USB, NFC, and so on. The NFC chip refers to a chip operating with the NFC method using 13.56 MHz bandwidth among various RF-ID frequency bandwidths such as 135 kHz, 13.56 MHz, 433 MHz, 860-960 MHz, 2.45 GHz, or the like. When the WI-FI chip or the Bluetooth chip is used, various connection information such as SSID and session key may be first exchanged, communication may be connected by using the connection information, and various information may be exchanged. The wireless communication chip refers to a chip performing communication according to various communication standards such as IEEE, Zigbee, 3G, 3GPP, LTE, and so on.

Meanwhile, although it is described above that the communicator 220 is one of the elements, in another implementation, the first communicator (not illustrated) for performing communication with the server device 100 and the second communicator (not illustrated) for performing communication with another server device (not illustrated) may be individually provided. Further, a method for communicating with the first communicator may be same as a method for communicating with the second communicator or different from each other.

A plurality of decoders 230 may perform decoding in parallel. Specifically, a plurality of decoders 230 may decode a plurality of encoded frames received in real time in parallel to convert them into another signal form.

A plurality of decoders 230 may perform decoding on a block basis through entropy decoding, dequantization, inverse transformation, filtering, or the like, but is not limited thereto.

A plurality of decoders 230 may be different types from each other. For example, the first decoder of a plurality of decoders 230 may be HEVC decoder, and the other decoders of a plurality of decoders 230 may be H.264 decoder. However, this is merely an example embodiment, and accordingly, the plurality of decoders 230 may be modified as desired. Further, a plurality of decoders 230 may be same as each other.

Each of the decoders may perform intra decoding or inter decoding for each of the frames.

The intra decoding may refer, for example, to an operation of performing decoding by referring to adjacent pixels in a current frame spatially.

The inter decoding may refer, for example, to an operation of performing decoding by referring between the screens. The decoder may restore some reference frames having high correlativity with a frame to be encoded currently, and referring between the screens by using the restored ones. In other words, the decoder may perform decoding by referring temporally to the reference frames of the previous frames.

At least one buffer 240 may be connected to a plurality of decoders 230. In an example, at least one buffer 240 may temporally store decoded frames output from a plurality of decoders 230.

The processor 250 may include various processing circuitry and control the overall operation of the user terminal device 200.

The processor 250 may sequentially allocate to a plurality of decoders 230 a plurality of encoded frames output in parallel from a plurality of encoders provided in the server device 100 and individually streamed from the server device 100. For example, the processor 250 may allocate encoded frames received from the first channel to the first decoder, and allocate encoded frames received from the second channel to the second decoder.

Meanwhile, there may be provided any number of decoders 230. However, only some of a plurality of decoders 230 may be used. For example, the decoders as many as channels used in the streaming may only be used among a plurality of decoders 230.

The processor 250 may store a plurality of decoded frames output in parallel from a plurality of decoders 230 in at least one buffer 240, and display a plurality of decoded frames in order on the display 210 based on identification information included in a plurality of decoded frames stored in at least one buffer 240.

Meanwhile, when an error occurs in the decoding of a certain frame, the processor 250 may transmit a re-request signal for a certain frame to the server device 100, and display a plurality of frames output from the rest decoders other than the decoder corresponding to a certain frame in order.

Meanwhile, the processor 250 may sequentially allocate encoded frames including video data streamed individually from the server device 100 and encoded frames including UI data provided with the video data, and synchronize the decoded UI data frame output respectively from a plurality of decoders 230 with the decoded video data frame and display a result.

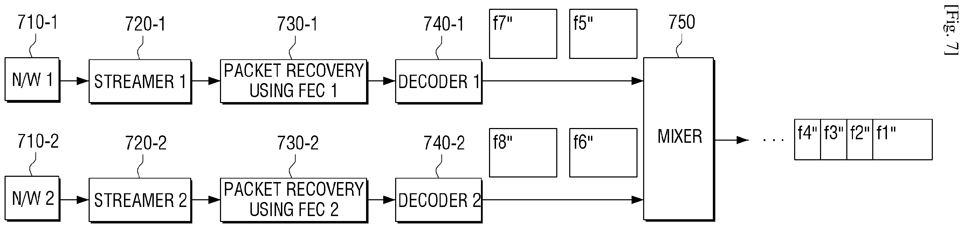

FIG. 7 is a diagram illustrating example content displaying of a user terminal device 200 according to an example embodiment.

The streamer 1 720-1 and the streamer 2 720-2 may receive a plurality of individually-streamed, encoded frames from the server device 100 through the network 1 710-1 (N/W 1) and the network 2 720-2 (N/W 2), respectively.

An error correction block 730-1 using FEC 1 may correct errors by using error correction signs included in the encoded frame received from the streamer 1 720-1. An error correction block 730-2 using FEC 2 may correct errors using error correction signals included in the encoded frames received from the streamer 1 720-2. In this example, the error correction block 730-1 using FEC 1 and the error correction block 730-2 using FEC 2 may be elements of the processor 250.

The processor 250 may allocate the error correction block using FEC respectively corresponding to encoded frames based on the QoS information received from the server device. At this process, QoS information may include information regarding a type of the encoder and a type of the forward error correction algorithms, which are respectively applied to encoded frames.

The first decoder 740-1 and the second decoder 740-2 may sequentially decode encoded respectively input frames. In an example, the first decoder 740-1 and the second decoder 740-2 may be different decoders from each other. For example, the first decoder 740-1 may be HEVC decoder, and the second decoder 740-2 may be H.264 decoder.

The processor 250 may allocate the decoder respectively corresponding to encoded frames based on the QoS information received from the server device 100.

FIG. 7 illustrates decoded frames (f1", f2", ? , f9", ?), thus indicating that the frames (f1, f2, ?, f9 ?) before encoding is similar to the decoded frames, but are not same. However, the present disclosure is not limited to any specific embodiment. Accordingly, when the lossless encoder and decoder are used, frames before encoding may be same as the frames after decoding.

A mixer 750 may be one element of the processor 250 and at least one buffer 240. The mixer 750 may output a plurality of decoded frames output in parallel from the first decoder 740-1 and the second decoder 740-2 in order based on each identification information. In an example, the mixer 750 may be referred to as a 'joiner'. Decoded frames may include identification information. For example, decoded frames may include presentation time stamp (PTS) information.

Meanwhile, the streamer 1 720-1 and the streamer 2 720-2 may receive a plurality of individually-streamed, encoded frames from the server device 100; however, receiving time may be different from each other in a plurality of encoded frames. Further, the error correction block 730-1 using FEC 1 and the error correction block 730-2 using FEC 2 may have different error correction time from each other, and respective time for processing one frame may be different. Further, respective decoding time may be different from each other in the first decoder 740-1 and the second decoder 740-2, and respective time for processing one frame may be different. In other words, the mixer 750 may receive a plurality of decoded frames irrespective of an order. Accordingly, the mixer 750 may temporally store some frames, and output the frames in order based on the order of displaying to a user.

Meanwhile, although FIG. 7 describes that two decoders are used, any desired number of decoders may be used, and even in this case, content may be stored with the same method. When a plurality of decoders are used, the first decoder of a plurality of decoders may be HEVC decoder, and the rest decoders of a plurality of decoders may be H.264 decoder.

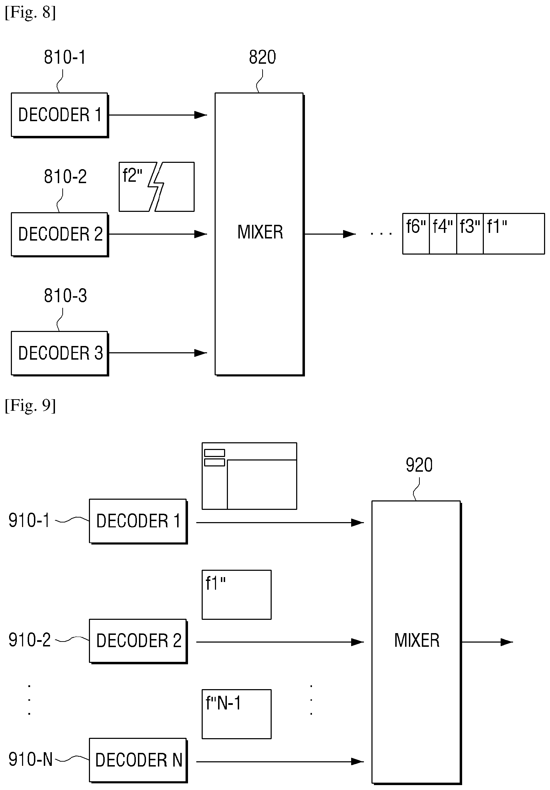

FIG. 8 is a diagram illustrating an example operation of transmitting a re-request signal for a certain frame according to an example embodiment.

As illustrated in FIG. 8, when an error occurs during decoding of a certain frame, the processor 250 may transmit a re-request signal for a certain frame to the server device 100. However, the present disclosure may not be limited to the above. Accordingly, the processor 250 may transmit to the server device 100 a re-request signal for a certain frame as an error occurs in a receiving process or an error correcting process, rather than in a decoding process of a certain frame.

In an example, the processor 250 may display a plurality of frames output from the rest decoders other than the decoder corresponding to the certain frame in order. For example, when an error occurs in a decoding process of the second encoded frame, the processor 250 may transmit a re-request signal for the second encoded frame to the server device 100, and display the first decoded frame, the third decoded frame, the fourth decoded frame, the sixth decoded frame, and then on in order.

In an example, the first decoded frame and the fourth decoded frame may be frames output from the first decoder 810-1, and the third decoded frame and the sixth decoded frame may be frames output from the third decoder 810-3.

The second decoder 810-2 is supposed to sequentially output the second decoded frame, the fifth decoded frame, and then on, but the subsequent frames may not be output as the second decoded frame is not output.

However, the present disclosure may not be limited to the examples discussed herein. Accordingly, the processor 250 may transmit a re-request signal for a certain frame, and display the frames including the certain frame in order when the certain frame is received from the server device 100 and decoded before displaying.

For example, in the above embodiment, when the second decoded frame is received from the server device 100 and decoded before displaying, the processor may display in order the first decoded frame, the second decoded frame, the third decoded frame, the fourth decoded frame, the fifth decoded frame, the sixth decoded frame, and then on. FIG. 9 is a diagram illustrating an example method for restoring a multi-window frame according to an example embodiment.

As illustrated in FIG. 9, the processor 250 may sequentially allocate an encoded frame including video data individually streamed from the server device 100 and an encoded frame including UI data provided with the video data to a plurality of decoders 230.

The processor 250 may synchronize decoded UI data frame respectively output from a plurality of decoders with the decoded video data frame and display a result. In an example, the processor 250 may divide the decoded UI data frame and the decoded video data frame based on information received from the server device 100, e.g., based on the information regarding a network over which the encoded frame corresponding to the frame 520 including UI data is transmitted, and the information regarding a network over which a plurality of encoded frames corresponding to the frame 510 including the video data is transmitted.

The mixer 920 may sequentially output a plurality of decoded video data frames output from the second decoder 910-2, ?, the Nth decoder 910-N. The outputting may be same as described above with reference to FIG. 7, which will not be repeated here.

The processor 250 may synchronize the decoded UI data frame and the decoded video data frame based on the information received from the server device 100 regarding a region of the frame including UI data where the video is to be displayed.

However, the present disclosure may not be limited to the above. Accordingly, when one region of the decoded UI data frame is processed with a preset color, the processor 250 may determine the region processed with the preset color to be a region where the video data is to be displayed. In this case, the processor 250 may not receive from the frame including UI data from the server device 100 information regarding a region where the video data is to be displayed.

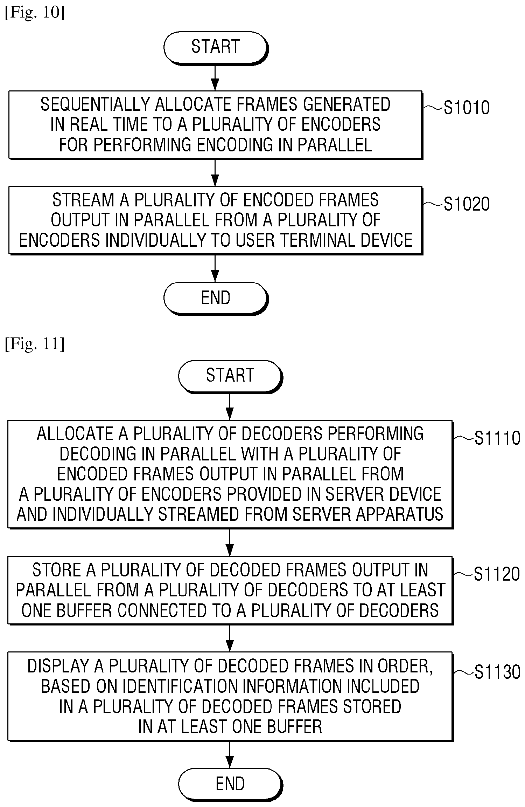

FIG. 10 is a flowchart illustrating an example control method of a server device according to an example embodiment.

At S1010, frames generated in real time may be sequentially allocated to a plurality of encoders for performing encoding in parallel. Further, a plurality of encoded frames output in parallel from a plurality of encoders may be individually streamed by the user terminal device, at S1020.

In an example, a plurality of encoders may include a first encoder and a second encoder, and the allocating at S1010 may allocate odd-numbered frames of the real-time generated frames to the first encoder and even-numbered frames to the second encoder.

Meanwhile, the control method may further include receiving a re-request signal for a certain frame from the user terminal device and re-transmitting the certain frame when the certain frame is encoded in a first encoding type and when the certain frame is encoded in a second encoding type, re-transmitting a frame encoded in a first encoding type after the certain frame of encoded frames output from the encoder that encodes the certain frame.

In an example, the re-transmitting may first re-transmit the certain frame when the certain frame is an intra frame, while, when the certain frame is an inter frame and, the re-transmitting may first re-transmit an intra frame after the certain frame of encoded frames output from the encoder that encodes the certain frame.

Meanwhile, when a frame including video data and a frame including UI data provided with the video data are generated, the allocating at S1010 may allocate a frame including UI data to one of a plurality of encoders and sequentially allocate a frame including video data to the rest of a plurality of encoders.

FIG. 11 is a flowchart illustrating an examplme control method of a user terminal device according to an example embodiment.

A plurality of encoded frames output in parallel from a plurality of encoders provided in the server device and individually streamed from the server device may be sequentially allocated to a plurality of decoders performing decoding in parallel, at S1110. Further, a plurality of decoded frames output in parallel from a plurality of decoders may be stored in at least one buffer connected to a plurality of decoders, at S1120. Further, a plurality of decoded frames may be displayed in order based on identification information included in a plurality of decoded frames stored in at least one buffer, at S1130.

In an example, the control method may further include transmitting a re-request signal for a certain frame to the server device when an error occurs during the decoding of a certain frame, and the displaying at S1130 may display in order a plurality of frames output from the rest decoders other than the decoder corresponding to a certain frame among a plurality of decoders.

Meanwhile, the allocating at S1110 may further include allocating sequentially the encoded frame including video data individually streamed from the server device and the encoded frame including UI data provided with the video data to a plurality of decoders, and the synchronizing the decoded UI data frame respectively output from a plurality of decoders with the decoded video data frame and displaying a result.

According to the above various example embodiments, the server device and the user terminal device may provide high quality streaming service as high capacity content are processed by using a plurality of encoders and a plurality of decoders.

Meanwhile, although it is described above that the server device and the user terminal device are described separately from each other, the server device and the user terminal device may be configured as one system.

Meanwhile, although it is described above that a plurality of encoders and a plurality of decoders are implemented as hardware, the present disclosure may not be limited herein. For example, the processor may perform operation of a plurality of encoders and a plurality of decoders using software, hardware or any combination thereof.

Meanwhile, the method according to the above various example embodiments may be stored in various recording media. Accordingly, the methods according to the various embodiments may be implemented in various types of electronic devices implementing recording media.

Specifically, there may be provided a non-transitory computer readable recording medium stored with programs for sequentially performing the control method described above.

The non-transitory computer readable recording medium refers to a medium that stores data and that can be read by devices. Specifically, the various applications or programs described above may be stored and provided on non-transitory computer readable recording medium such as CD, DVD, hard disk, Blu-ray disk, USB, memory card, or ROM.

The foregoing example embodiments and advantages are merely examples and are not to be construed as limiting the example embodiments or the present disclosure. The present teaching can be readily applied to other types of devices. Also, the description of the example embodiments of the present disclosure is intended to be illustrative, and not to limit the scope of the claims.

## Claims

1. A server device (100), comprising:
a communicator comprising communication circuitry configured to perform communication with a user terminal device (200);
a plurality of encoders (120) configured to perform encoding in parallel; and
a processor (130) configured to sequentially allocate frames generated in real time to the plurality of encoders, and to control the communicator so that a plurality of encoded frames output in parallel from the plurality of encoders are streamed individually to the user terminal device;
wherein when a re-request signal for a certain frame is received from the user terminal device, the processor (130) is configured to continue transmitting encoded frames output from the rest of the plurality of the encoders other than the certain encoder corresponding to the certain frame, irrespective of the re-request signal and before transmitting any other encoded frames output from the certain encoder, the processor is further configured to:
when the certain frame is a frame encoded in a first encoding type, first re-transmit the certain frame, and
when the certain frame is a frame encoded in a second encoding type, first re-transmit the previously transmitted frame which was the first frame encoded in the first encoding type that was output from the certain encoder following the output of the certain frame.

2. The server device of claim 1, wherein the plurality of encoders (120) comprise a first encoder and a second encoder, and
the processor (130) is configured to allocate odd-numbered frames of the frames generated in real time to the first encoder and to allocate even-numbered frames to the second encoder.

3. The server device of claim 1, wherein, when a re-request signal for a certain frame is received from the user terminal device, the processor (130) is configured to first re-transmit the certain frame if the certain frame is an intra frame, and if the certain frame is an inter frame, to first re-transmit an intra frame after the certain frame of the encoded frames is output from the encoder that encodes the certain frame.

4. The server device of claim 1, wherein, when a frame including video data and a frame including User Interface, UI, data provided with the video data is generated, the processor (130) is configured to allocate a frame including the UI data to one of the plurality of encoders (120), and to sequentially allocate a frame including the video data to remaining encoders of the plurality of encoders (120).

5. A user terminal device (200), comprising:
a display (210);
a communicator (220) comprising communication circuitry configured to perform communication with a server device (100);
a plurality of decoders (230) configured to perform decoding in parallel;
at least one buffer (240) connected to the plurality of decoders (230); and
a processor (250) configured to sequentially allocate to a plurality of decoders (230) a plurality of encoded frames output in parallel from a plurality of encoders (120) provided in the server device (100) and streamed individually from the server device (100), to store a plurality of decoded frames output in parallel from the plurality of decoders (230) in at least one buffer, and to display the plurality of decoded frames in order on the display (210) based on identification information included in the plurality of decoded frames stored in the at least one buffer (240),
wherein the processor (250) is configured to transmit a re-request signal for a certain frame to the server device when an error occurs in the decoding of the certain frame, while continuing to display in order a plurality of frames output from remaining decoders other than the decoder corresponding to the certain frame from among the plurality of decoders (230).

6. The user terminal device of claim 5, wherein the processor (250) is configured to sequentially allocate to the plurality of decoders (230) an encoded frame including video data individually streamed from the server device, to allocate an encoded frame including User Interface, UI, data provided with the video data, to synchronize the decoded video data frame with the decoded UI data frame output respectively from the plurality of decoders, and display a result.

7. A control method of a server device (100), comprising:
sequentially allocating frames generated in real time to a plurality of encoders (120) for performing encoding in parallel;
individually streaming a plurality of encoded frames output in parallel from the plurality of encoders (120) to a user terminal device (200),
and upon receiving a re-request signal for a certain frame from the user terminal device, continuing transmitting encoded frames output from the rest of the plurality of the encoders other than the certain encoder corresponding to the certain frame, irrespective of the re-request signal and before transmitting any other encoded frames output from the certain encoder:
when the certain frame is a frame encoded in a first encoding type, first re-transmitting the certain frame, and
when the certain frame is a frame encoded in a second encoding type, first re-transmitting the previously transmitted frame which was the first frame encoded in the first encoding type that was output from the certain encoder following the output of the certain frame.

8. The method of claim 7, wherein the plurality of encoders (120) comprise a first encoder and a second encoder, and
the allocating comprises allocating odd-numbered frames of the frames generated in real time to the first encoder and allocating even-numbered frames generated in real time to the second encoder.

9. The method of claim 7, wherein the re-transmitting comprises first re-transmitting the certain frame when the certain frame is an intra frame, and when the certain frame is an inter frame, first re-transmitting the intra frame after the certain frame of encoded frames is output from the encoder that encodes the certain frame.

10. The control method of claim 7, wherein, when a frame including video data and a frame including User Interface, UI, data provided with the video data is generated, the allocating comprises allocating the frame including the UI data to one of the plurality of encoders (120), and sequentially allocating the frame including the video data to remaining encoders of the plurality of encoders.

## Patentansprüche

1. Server-Vorrichtung (100), die Folgendes umfasst:
einen Kommunikator, der eine Kommunikationsschaltungsanordnung enthält, die konfiguriert ist, eine Kommunikation mit einer Anwenderendgerätvorrichtung (200) auszuführen;
mehrere Codierer (120), die konfiguriert sind, parallel zu codieren; und
einen Prozessor (130), der konfiguriert ist, Rahmen, die in Echtzeit erzeugt werden, den mehreren Codierern sequentiell zuzuweisen und den Kommunikator so zu steuern, dass mehrere codierte Rahmen, die von den mehreren Codierern parallel ausgegeben werden, einzeln an die Anwenderendgerätvorrichtung gestreamt werden;
wobei dann, wenn ein Neuanforderungssignal für einen bestimmten Rahmen von der Anwenderendgerätvorrichtung empfangen wird, der Prozessor (130) konfiguriert ist, das Senden codierter Rahmen, die vom Rest der mehreren Codierer mit Ausnahme des bestimmten Codierers, der dem bestimmten Rahmen entspricht, ausgegeben werden, unabhängig von dem Neuanforderungssignal fortzusetzen, und wobei der Prozessor ferner konfiguriert ist, vor dem Senden irgendwelcher anderer codierter Rahmen, die von dem bestimmten Codierer ausgegeben werden,
dann, wenn der bestimmte Rahmen ein gemäß einem ersten Codierungstyp codierter Rahmen ist, den bestimmten Rahmen erstmals neu zu senden, und
dann, wenn der bestimmte Rahmen ein gemäß einem zweiten Codierungstyp codierter Rahmen ist, den früher gesendeten Rahmen, der der erste Rahmen war, der gemäß dem ersten Codierungstyp codiert ist, der von dem bestimmten Codierer ausgegeben wurde, nachdem der bestimmte Rahmen ausgegeben wurde, erstmals neu zu senden.

2. Server-Vorrichtung nach Anspruch 1, wobei die mehreren Codierer (120) einen ersten Codierer und einen zweiten Codierer umfassen und
der Prozessor (130) konfiguriert ist, ungeradzahlige Rahmen der Rahmen, die in Echtzeit erzeugt werden, dem ersten Codierer zuzuweisen und geradzahlige Rahmen dem zweiten Codierer zuzuweisen.

3. Server-Vorrichtung (1), wobei dann, wenn ein Neuanforderungssignal für einen bestimmten Rahmen von der Anwenderendgerätvorrichtung empfangen wird, der Prozessor (130) konfiguriert ist, den bestimmten Rahmen erstmals neu zu senden, falls der bestimmte Rahmen ein Intra-Rahmen ist, und dann, wenn der bestimmte Rahmen ein Inter-Rahmen ist, einen Intra-Rahmen erstmals neu zu senden, nachdem der bestimmte Rahmen der codierten Rahmen von dem Codierer, der den bestimmten Rahmen codiert, ausgegeben worden ist.

4. Server-Vorrichtung nach Anspruch 1, wobei dann, wenn ein Rahmen, der Videodaten enthält, und ein Rahmen, der Anwenderschnittstellendaten, UI-Daten, enthält, die mit den Videodaten bereitgestellt werden, erzeugt wird, der Prozessor (130) konfiguriert ist, einen Rahmen, der die UI-Daten enthält, einem der mehreren Codierer (120) zuzuweisen und einen Rahmen, der die Videodaten enthält, verbleibenden Codierern der mehreren Codierer (120) sequentiell zuzuweisen.

5. Anwenderendgerätvorrichtung (200), die Folgendes umfasst:
eine Anzeige (210);
einen Kommunikator (220), der eine Kommunikationsschaltungsanordnung enthält, die konfiguriert ist, eine Kommunikation mit einer Server-Vorrichtung (100) auszuführen;
mehrere Decodierer (230), die konfiguriert sind, ein Decodieren parallel auszuführen;
wenigstens einen Puffer (240), der mit den mehreren Decodierern (230) verbunden ist; und
einen Prozessor (250), der konfiguriert ist, den mehreren Decodierern (230) mehrere codierte Rahmen, die von mehreren Codierern (120), die in der Server-Vorrichtung (100) vorgesehen sind, parallel ausgegeben und von der Server-Vorrichtung (100) einzeln gestreamt werden, sequentiell zuzuweisen und mehrere decodierte Rahmen, die von den mehreren Decodierern (230) parallel ausgegeben werden, in wenigstens einem Puffer zu speichern und die mehreren decodierten Rahmen der Reihe nach auf der Anzeige (210) anhand von Identifizierungsinformationen, die in den mehreren decodierten Rahmen, die in dem wenigstens einen Puffer (240) gespeichert sind, enthalten sind, anzuzeigen,
wobei der Prozessor (250) konfiguriert ist, ein Neuanforderungssignal für einen bestimmten Rahmen zu der Server-Vorrichtung zu senden, wenn beim Decodieren des bestimmten Rahmens ein Fehler auftritt, während er fortgesetzt der Reihe nach mehrere Rahmen, die von verbleibenden Decodierern der mehreren Decodierer (230) mit Ausnahme des Decodierers, der dem bestimmten Rahmen entspricht, ausgegeben werden, anzeigt.

6. Anwenderendgerätvorrichtung nach Anspruch 5, wobei der Prozessor (250) konfiguriert ist, den mehreren Decodierern (230) einen codierten Rahmen, der Videodaten enthält, die von der Server-Vorrichtung einzeln gestreamt werden, sequentiell zuzuweisen, um einen codierten Rahmen, der Anwenderschnittstellen-Daten, UI-Daten, die mit den Videodaten bereitgestellt werden, zuzuweisen, um den decodierten Videodatenrahmen mit dem decodierten UI-Daten-Rahmen, die von den jeweiligen mehreren Decodierern ausgegeben werden, zu synchronisieren und ein Ergebnis anzuzeigen.

7. Steuerverfahren für eine Server-Vorrichtung (100), das Folgendes umfasst:
sequentielles Zuweisen von Rahmen, die in Echtzeit erzeugt werden, zu mehreren Codierern (120), um eine Codierung parallel auszuführen;
einzelnes Streamen mehrerer codierter Rahmen, die von den mehreren Codierern (120) parallel ausgegeben werden, zu einer Anwenderendgerätvorrichtung (200) und
bei Empfang eines Neuanforderungssignals für einen bestimmten Rahmen von der Anwenderendgerätvorrichtung und unabhängig von dem Neuanforderungssignal fortgesetztes Senden codierter Rahmen, die von dem Rest der mehreren Codierern mit Ausnahme des bestimmten Codierers, der dem bestimmten Rahmen entspricht, ausgegeben werden, und vor dem Senden irgendwelcher anderer codierter Rahmen, die von dem bestimmten Codierer ausgegeben werden:
dann, wenn der bestimmte Rahmen ein gemäß einem ersten Codierungstyp codierter Rahmen ist, erstmaliges erneutes Senden des bestimmten Rahmens, und
dann, wenn der bestimmte Rahmen ein gemäß einem zweiten Codierungstyp codierter Rahmen ist, erstmaliges erneutes Senden des früher gesendeten Rahmens, der der erste gemäß dem ersten Codierungstyp codierte Rahmen war, der von dem bestimmten Codierer ausgegeben wurde, nachdem der bestimmte Rahmen ausgegeben worden ist.

8. Verfahren nach Anspruch 7, wobei die mehreren Codierer (120) einen ersten Codierer und einen zweiten Codierer umfassen und
das Zuweisen das Zuweisen ungeradzahliger Rahmen der Rahmen, die in Echtzeit erzeugt werden, zu dem ersten Codierer und das Zuweisen geradzahliger Rahmen, die in Echtzeit erzeugt werden, zu dem zweiten Codierer umfasst.

9. Verfahren nach Anspruch 7, wobei das erneute Senden das erstmalige erneute Senden des bestimmten Rahmens, wenn der bestimmte Rahmen ein Intra-Rahmen ist, und das erstmalige erneute Senden des Intra-Rahmens, wenn der bestimmte Rahmen ein Inter-Rahmen ist, nachdem der bestimmte Rahmen von codierten Rahmen von dem Codierer, der den bestimmten Rahmen codiert hat, ausgegeben wird, umfasst.

10. Steuerverfahren nach Anspruch 7, wobei dann, wenn ein Rahmen, der Videodaten enthält, und ein Rahmen, der Anwenderschnittstellen-Daten, UI-Daten, die mit den Videodaten bereitgestellt werden, enthält, erzeugt werden, das Zuweisen das Zuweisen des Rahmens, der die UI-Daten enthält, zu einem der mehreren Codierer (120) und das sequentielle Zuweisen des Rahmens, der die Videodaten enthält, zu verbleibenden Codierern der mehreren Codierer umfasst.

## Revendications

1. Dispositif serveur (100), comprenant :
un dispositif de communication comprenant des circuits de communication configurés pour effectuer une communication avec un dispositif terminal d'utilisateur (200) ;
une pluralité de codeurs (120) configurés pour effectuer un codage en parallèle ; et
un processeur (130) configuré pour allouer successivement des trames générées en temps réel à la pluralité de codeurs et pour commander le dispositif de communication de sorte qu'une pluralité de trames codées sorties en parallèle de la pluralité de codeurs sont diffusées en continu individuellement au dispositif terminal d'utilisateur ;
dans lequel quand un signal de redemande pour une certaine trame est reçu du dispositif terminal d'utilisateur, le processeur (130) est configuré pour continuer à transmettre des trames codées sorties du reste de la pluralité des codeurs autres que le certain codeur correspondant à la certaine trame, indépendamment du signal de redemande et avant de transmettre toute autre trame codée sortie du certain codeur, le processeur étant en outre configuré pour :
lorsque la certaine trame est une trame codée selon un premier type de codage, retransmettre d'abord la certaine trame, et
lorsque la certaine trame est une trame codée selon un deuxième type de codage, retransmettre d'abord la trame transmise précédemment qui était la première trame codée selon le premier type de codage qui a été sortie du certain codeur suite à la sortie de la certaine trame.

2. Dispositif serveur selon la revendication 1, dans lequel la pluralité de codeurs (120) comprend un premier codeur et un deuxième codeur, et
le processeur (130) est configuré pour allouer des trames impaires parmi les trames générées en temps réel au premier codeur et pour allouer des trames paires au deuxième codeur.

3. Dispositif serveur selon la revendication 1, dans lequel, lorsqu'un signal de redemande pour une certaine trame est reçu du dispositif terminal d'utilisateur, le processeur (130) est configuré pour retransmettre d'abord la certaine trame si la certaine trame est une intra-trame, et si la certaine trame est une inter-trame, pour retransmettre d'abord une intra-trame après que la certaine trame des trames codées a été sortie du codeur qui code la certaine trame.

4. Dispositif serveur selon la revendication 1, dans lequel, lorsqu'une trame comprenant des données vidéo et une trame comprenant des données d'interface utilisateur, UI, fournies avec les données vidéo sont générées, le processeur (130) est configuré pour allouer une trame comprenant les données d'UI à l'un de la pluralité de codeurs (120), et pour allouer successivement une trame comprenant les données vidéo aux codeurs restants de la pluralité de codeurs (120).

5. Dispositif terminal d'utilisateur (200), comprenant :
un affichage (210) ;
un dispositif de communication (220) comprenant des circuits de communication configurés pour effectuer une communication avec un dispositif serveur (100) ;
une pluralité de décodeurs (230) configurés pour effectuer un décodage en parallèle ;
au moins une mémoire tampon (240) connectée à la pluralité de décodeurs (230) ; et
un processeur (250) configuré pour allouer successivement à une pluralité de décodeurs (230) une pluralité de trames codées sorties en parallèle d'une pluralité de codeurs (120) prévus dans le dispositif serveur (100) et diffusées en continu individuellement depuis le dispositif serveur (100), pour stocker une pluralité de trames décodées sorties en parallèle depuis la pluralité de décodeurs (230) dans au moins une mémoire tampon, et pour afficher la pluralité de trames décodées dans l'ordre sur l'affichage (210) sur la base d'informations d'identification comprises dans la pluralité de trames décodées stockées dans ladite au moins une mémoire tampon (240),
dans lequel le processeur (250) est configuré pour transmettre un signal de redemande pour une certaine trame au dispositif serveur lorsqu'une erreur survient dans le décodage de la certaine trame, tout en continuant à afficher dans l'ordre une pluralité de trames sorties des décodeurs restants autres que le décodeur correspondant à la certaine trame parmi la pluralité de décodeurs (230).

6. Dispositif terminal d'utilisateur selon la revendication 5, dans lequel le processeur (250) est configuré pour allouer successivement à la pluralité de décodeurs (230) une trame codée comprenant des données vidéo, diffusée en continu individuellement depuis le dispositif serveur, pour allouer une trame codée comprenant des données d'interface utilisateur, UI, fournies avec les données vidéo, pour synchroniser la trame de données vidéo décodée avec la trame de données d'UI décodée, sorties respectivement depuis la pluralité de décodeurs, et pour afficher un résultat.

7. Procédé de commande d'un dispositif serveur (100), comprenant les étapes consistant à :
allouer successivement des trames générées en temps réel à une pluralité de codeurs (120) pour effectuer un codage en parallèle ;
diffuser en continu individuellement une pluralité de trames codées sorties en parallèle de la pluralité de codeurs (120) à un dispositif terminal d'utilisateur (200), et à la réception d'un signal de redemande pour une certaine trame du dispositif terminal d'utilisateur, continuer à transmettre des trames codées sorties depuis le reste de la pluralité des codeurs autres que le certain codeur correspondant à la certaine trame, indépendamment du signal de redemande et avant de transmettre toute autre trame codée sortie du certain codeur :
lorsque la certaine trame est une trame codée selon un premier type de codage, retransmettre d'abord la certaine trame, et
lorsque la certaine trame est une trame codée selon un deuxième type de codage, retransmettre d'abord la trame transmise précédemment qui était la première trame codée selon le premier type de codage qui a été sortie du certain codeur suite à la sortie de la certaine trame.

8. Procédé selon la revendication 7, dans lequel la pluralité de codeurs (120) comprend un premier codeur et un deuxième codeur, et
l'allocation comprend l'allocation des trames impaires parmi les trames générées en temps réel au premier codeur et l'allocation des trames paires générées en temps réel au deuxième codeur.

9. Procédé selon la revendication 7, dans lequel la retransmission comprend la retransmission d'abord de la certaine trame lorsque la certaine trame est une intra-trame, et lorsque la certaine trame est une inter-trame, la retransmission d'abord de l'intra-trame après que la certaine trame des trames codées a été sortie du codeur qui code la certaine trame.

10. Procédé de commande selon la revendication 7, dans lequel, lorsqu'une trame comprenant des données vidéo et une trame comprenant des données d'interface utilisateur, UI, fournies avec les données vidéo sont générées, l'allocation comprend l'allocation de la trame comprenant les données d'UI à l'un de la pluralité de codeurs (120), et l'allocation successive de la trame comprenant les données vidéo aux codeurs restants de la pluralité de codeurs.
